# EUROPÄISCHE PATENTSCHRIFT

(11) **EP 0 756 761 B1**
(45) Veröffentlichungstag und Bekanntmachung des Hinweises auf die Patenterteilung: **24.06.1998**
(21) Anmeldenummer: 95915121.8
(22) Anmeldetag: 04.04.1995
(51) Int. Cl.: H01L 29/10, H01L 29/423, H01L 29/78, H01L 21/336, H01L 21/20

(54) **MIKROELEKTRONISCHES BAUELEMENT UND VERFAHREN ZU DESSEN HERSTELLUNG**
MICRO-ELECTRONIC COMPONENT AND PROCESS FOR MAKING IT
COMPOSANT MICROELECTRONIQUE ET SON PROCEDE DE FABRICATION

(30) Priorität: 19.04.1994 DE 4413470
(43) Veröffentlichungstag der Anmeldung: 05.02.1997
(73) Patentinhaber: SIEMENS AKTIENGESELLSCHAFT, 80333 München (DE)
(72) Erfinder: GOSSNER, Harald, D-81735 München (DE); EISELE, Ignaz, D-82057 Icking (DE); RISCH, Lothar, D-85579 Neubiberg (DE); HAMMERL, Erwin, Stormville, NY 12582 (US)
(86) Internationale Anmeldenummer: DE9500448
(87) Internationale Veröffentlichungsnummer: WO9528741

(56) Entgegenhaltungen:
- DE-A- 3 545 243
- PATENT ABSTRACTS OF JAPAN vol. 18 no. 280 (E-1555) ,25.Mai 1994 & JP,A,06 053488 (NIPPON STEEL CORP) 25.Februar 1994,
- PATENT ABSTRACTS OF JAPAN vol. 14 no. 441 (E-0981) ,20.September 1990 & JP,A,02 174268 (FUJITSU LTD) 5.Juli 1990,
- PATENT ABSTRACTS OF JAPAN vol. 17 no. 313 (E-1381) ,15.Juni 1993 & JP,A,05 029613 (MATSUSHITA ELECTRIC IND CO LTD) 5.Februar 1993,
- PATENT ABSTRACTS OF JAPAN vol. 4 no. 97 (E-018) ,12.Juli 1980 & JP,A,55 061070 (FUJITSU LTD) 8.Mai 1980,
- PATENT ABSTRACTS OF JAPAN vol. 5 no. 137 (E-072) ,29.August 1981 & JP,A,56 071974 (FUJITSU LTD) 15.Juni 1981,
- PATENT ABSTRACTS OF JAPAN vol. 10 no. 376 (E-464) ,13.Dezember 1986 & JP,A,61 170070 (SONY CORP) 31.Juli 1986,
- PATENT ABSTRACTS OF JAPAN vol. 17 no. 480 (E-1425) ,31.August 1993 & JP,A,05 121320 (FUJITSU LTD) 18.Mai 1993, & US-A-5 313 484 (FUJITSU LIMITED) 17.Mai 1994
- PATENT ABSTRACTS OF JAPAN vol. 18 no. 225 (E-1541) ,22.April 1994 & JP,A,06 021052 (SANYO ELECTRIC CO LTD) 28.Januar 1994,

## Beschreibung

Einzelelektronenbauelemente, die als erfolgversprechende Alternative für die herkömmliche CMOS-Technik in Richtung höhere Integrationsdichte und/oder höhere Schaltgeschwindigkeiten angesehen werden, weisen einen oder mehrere Knoten auf, die nur über hochohmige Potentialbarrieren umgeladen werden können. Diese Umladung wird durch einen quantenmechanischen Tunneleffekt erklärt. Die Umladung eines Knotens um eine Elementarladung entspricht einem Ladungstransport von einem Elektron über die Potentialbarriere. Dazu ist ein von der Kapazität des Knotens abhängiger Energieaufwand erforderlich. Solange die thermische Energie des Systems sehr viel kleiner als dieser Energieaufwand ist, ist dieser Ladungsübertritt verboten. Nur durch Anlegen einer äußeren Spannung ist ein Ladungsübertritt dann möglich.

Die Potentialbarriere ist nur wirksam, solange die Betriebstemperatur des Einzelelektronenbauelementes so klein ist, daß die thermische Energie des Systems viel kleiner als der für einen Ladungsübertritt erforderliche Energieaufwand ist.

Um das Einzelelektronen-Bauelement bei technisch handhabbaren Temperaturen, möglichst bei Zimmertemperatur, betreiben zu können, muß wegen der Energiebilanz die Kapazität und damit die Ausdehnung der Knoten möglichst gering gehalten werden.

Zur Realisierung eines Einzelelektronen-Bauelementes im Halbleitermaterial werden als Knoten leitfähige Gebiete sehr kleiner Abmessungen verwendet, die Quantendots genannt werden. Im Hinblick auf die Betriebstemperatur des Einzelelektronen-Bauelementes werden Quantendots mit Abmessungen unter 10 nm erforderlich. Leitfähige Gebiete, die nur in zwei Dimensionen geringe Abmessungen aufweisen, werden Quantenwires genannt.

Es ist vorgeschlagen worden (siehe zum Beispiel M. A. Reed, Spektrum der Wissenschaft 3 (1993) Seite 52 und J. Caro, Mictroelectronic Engineering 22 (1993) Seite 153), leitfähige Gebiete kleiner Abmessungen im Halbleitermaterial unter Verwendung von Gates als Inversionsschichten zu realisieren. Die erzielbaren Abmessungen derartiger leitfähiger Gebiete hängen von der Form der verwendeten Gates ab. Mit Hilfe von strukturierten Gates können dabei auch lokal begrenzte Inversionsschichten erzeugt werden. Inversionsschichten mit Abmessungen im Nanometerbereich erfordern dabei Gatestrukturen im Nanometerbereich, die nur durch aufwendige Lithographieverfahren mit entsprechender Auflösung herstellbar sind.

In R. Nötzel et al, Adv. Mater. 5 (1993) Seite 22 und K. Eberl et al, Appl. Phys. Lett. 63 (1993) Seite 1059, ist vorgeschlagen worden, GaAs/AlGaAs-Schichten zu verwenden, die nicht planar aufgewachsen werden. Dadurch wird eine laterale Strukturierung der leitenden Heteroschicht während des epitaktischen Wachsens erzielt.

In JP-A-6-53 488 wird ein Silizium-MOSFET mit einem Quantendraht-Kanal beschrieben, der durch kristallorientierungsabhängiges Ätzen realisiert wird.

Der Erfindung liegt das Problem zugrunde, ein Bauelement anzugeben, das als Einzelelektronen-Bauelement geeignet ist und das leitfähige Gebiete umfaßt, deren Ausdehnung nicht durch die verwendete lithographische Auflösung begrenzt ist. Weiterhin liegt der Erfindung das Problem zugrunde, ein Herstellungsverfahren für ein solches Bauelement anzugeben.

Dieses Problem wird gelöst durch ein Bauelement gemäß Anspruch 1 sowie ein Verfahren gemäß Anspruch 3. Weitere Ausgestaltungen der Erfindung gehen aus den Unteransprüchen hervor.

Das erfindungsgemaße Bauelement umfaßt ein Substrat, das mindestens im Bereich einer Hauptflache monokristallines Silizium aufweist. Das Substrat kann sowohl ein Silizium-Wafer als auch ein SOI-Substrat sein.

Im Bereich der Hauptflache weist das Substrat eine Oberflächenstruktur auf, die mindestens drei sich in einem Schnittbereich schneidende Flächen aufweist. Die sich schneidenden Flächen bilden eine Spitze von der aus Kanten auseinanderlaufen. Die Oberflächenstruktur ist mindestens im Bereich der sich schneidenden Flächen mit einem Gatedielektrikum bedeckt, auf dem eine Gateelektrode angeordnet ist.

Im Bereich der Hauptfläche sind mindestens zwei leitfähige Gebiete angeordnet, die gegenüber dem Substrat isoliert sind. Die leitfähigen Gebiete sind an verschiedenen Seiten der Oberflächenstruktur angeordnet und grenzen an die oder an eine der Kanten.

Durch Anlegen einer Steuerspannung an die Gateelektrode bildet sich entlang dem Schnittbereich der sich schneidenden Flächen eine Inversionsschicht aus. Ein Stromfluß zwischen den beiden leitfähigen Gebieten über diese Inversionsschicht ist durch Anlegen der Steuerspannung steuerbar.

Die Erfindung macht sich die Erkenntnis zunutze, daß in Silizium-MOS-Bauelementen an Spitzen oder Kanten der Silizium-Dielektrikum-Grenzfläche ein erhöhtes elektrisches Feld auftritt und damit in diesem Bereich schon bei Anliegen einer geringen Steuerspannung die Bedingungen für eine Inversionsschicht erfüllt sind. Das heißt, bei Anlegen einer Steuerspannung, bei der es an einer planaren Grenzfläche noch nicht zur Ausbildung einer Inversionsschicht kommt, bildet sich an Spitzen oder Kanten schon eine Inversionsschicht. Dabei ist wiederum für eine Inversionsschicht an einer Spitze eine geringere Steuerspannung als für eine Inversionsschicht an einer Kante erforderlich.

Die Oberflächenstruktur in dem erfindungsgemäßen Bauelement kann sowohl die Haupt fläche überragen, zum Beispiel als Pyramide aus Silizium, als auch eine Vertiefung in der Hauptflache darstellen.

Im Falle einer Vertiefung wird die Oberflächenstruktur vorzugsweise durch kristallorientierungsabhangiges Ätzen, zum Beispiel mit KOH oder Ethylendiamin hergestellt. Dadurch bildet sich in der Hauptfläche ein Graben mit V-förmigem Querschnitt.

Im Fall einer erhabenen Oberflächenstruktur liegt es im Rahmen der Erfindung, zur Herstellung auf der Hauptflache zunächst eine Hilfsstruktur zu erzeugen, die den Bereich für die Oberflächenstruktur abdeckt. Die Hauptfläche des Substrats wird dann isotrop selektiv zur Hilfsstruktur geätzt, bis die Hilfsstruktur durch Zusammenwachsen lateraler Unterätzungen abgehoben wird. Die Hilfsstruktur kann zum Beispiel aus SiO₂, Si₃N₄ oder einem Metall erzeugt werden. Die isotrope Ätzung erfolgt dann mit Flußsäure oder Phosphorsäure. Zur weiteren Anspitzung der Oberflächenstruktur liegt es im Rahmen der Erfindung, anschließend eine thermische Oxidation mit anschließendem Rückätzen des dabei gebildeten SiO₂ durchzuführen.

Vorzugsweise wird eine erhabene Oberflächenstruktur in dem erfindungsgemäßen Bauelement durch epitaktisches Aufwachsen von Silizium unter Verwendung einer Maske erzeugt. Dazu wird die Hauptflache außerhalb der Oberflächenstruktur mit der Maske abgedeckt. Beim epitaktischen Aufwachsen von Silizium wachsen bevorzugt {111}-Flächen, so daß sich eine Pyramide ausbildet. Es ist besonders vorteilhaft, die Pyramide durch lokale Molekularstraßepitaxie aufzuwachsen, da auf diese Weise ein Krümmungsradius an der Spitze von weniger als 10 nm erzielt werden kann.

Die Ausdehnung der Inversionsschichten in dem erfindungsgemäßen Bauelement ist abhängig von dem Krümmungsradius der Spitzen, der von lithographischen Schritten unabhängig ist. Bei einer epitaktisch aufgewachsenen Oberflächenstruktur hängt der Krümmungsradius nur von der Orientierung der aufgewachsenen Kristallflächen, nicht jedoch von lithographischen Schritten ab.

Ferner liegt es im Rahmen der Erfindung, die Oberflächenstruktur durch natürlich gewachsene Kristallstufen im Bereich der Hauptflache oder durch Verwendung eines Siliziumsubstrates mit bezüglich einer Kristallorientierung verkippter Hauptfläche zu realisieren. Ein solches Siliziumsubstrat mit verkippter Hauptfläche weist im Bereich der Hauptflache Kristallstufen auf. Es wird zum Beispiel durch Schleifen hergestellt.

Im folgenden wird die Erfindung anhand von Ausführungsbeispielen und den Figuren näher erläutert.
- Figur 1: zeigt einen Schnitt durch ein Siliziumsubstrat mit leitfähigen Gebieten, einer Siliziumoxidschicht und einer strukturierten Siliziumnitridschicht.
- Figur 2: zeigt das Siliziumsubstrat nach Strukturierung der Siliziumoxidschicht zur Bildung einer Maske.
- Figur 3: zeigt das Siliziumsubstrat nach epitaktischem Aufwachsen einer Pyramide.
- Figur 4: zeigt das Siliziumsubstrat nach Entfernen der Maske und Aufwachsen eines Gatedielektrikums.
- Figur 5: zeigt das Siliziumsubstrat nach Erzeugung von Gateelektrode, Sourceelektrode und Drainelektrode.
- Figur 6: zeigt eine Ansicht eines erfindungsgemäßen Bauelementes mit zwei leitfähigen Gebieten und einer pyramidenförmigen Oberflächenstruktur.
- Figur 7: zeigt eine Ansicht eines erfindungsgemäßen Bauelementes mit vier leitfähigen Gebieten und einer pyramidenförmigen Oberflächenstruktur.
- Figur 8: zeigt einen Schnitt durch ein Bauelement mit einer Oberflächenstruktur, die als Vertiefung in einer Hauptflache eines Substrats realisiert ist.
- Figur 9: zeigt den in Figur 8 mit IX-IX bezeichneten Schnitt durch Figur 8.

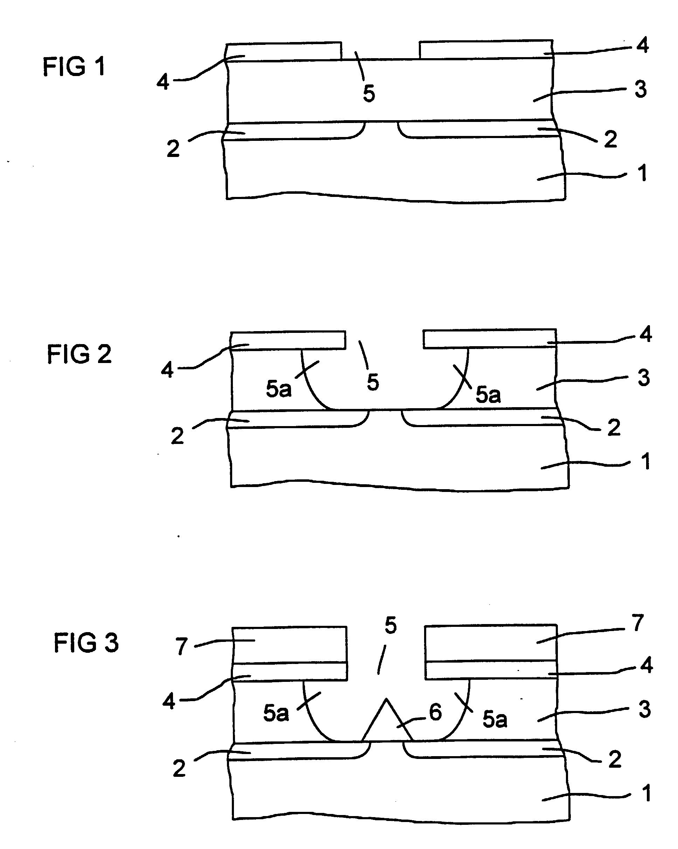

In einer Hauptfläche eines Substrates 1 aus zum Beispiel monokristallinem Silizium mit einer [100]-Oberfläche werden zum Beispiel durch maskierte Ionenimplantation zwei dotierte Gebiete 2 erzeugt (siehe Figur 1). Das Substrat 1 ist zum Beispiel p⁻-dotiert mit einer Dotierstoffkonzentration von 10¹⁶ bis 10¹⁸ cm⁻³. Die dotierten Gebiete 2 werden zum Beispiel n⁺-dotiert mit einer Dotierstoffkonzentration von 10¹⁹ bis 10²⁰ cm⁻³.

Auf die Hauptfläche des Substrats 1 wird ganzflächig durch thermische Oxidation bei zum Beispiel 1050°C eine 1 µm dicke Siliziumoxidschicht 3 aufgebracht. Auf die Siliziumoxidschicht 3 wird in einem LPCVD-Prozeß bei 700°C eine 50 bis 100 nm dicke Siliziumnitridschicht 4 aufgebracht. Unter Verwendung einer Maske (nicht dargestellt), die mittels konventioneller Photolithographie oder mit anderen Lithographieverfahren hergestellt wird, wird die Siliziumnitridschicht 4 durch anisotropes Ätzen in einem CF₄-Plasma strukturiert, so daß eine Öffnung 5 entsteht, in der die Oberfläche der Siliziumoxidschicht 3 freigelegt ist.

Unter Verwendung der strukturierten Siliziumnitridschicht 4 als Maske wird die Siliziumoxidschicht 3 selektiv zur Siliziumnitridschicht 4 zum Beispiel mit gepufferter Flußsäure geätzt. Dabei wird die Hauptfläche des Substrats 1 freigelegt. Gleichzeitig entstehen Unteratzungen 5a der Siliziumoxidschicht 3 unter die Siliziumnitridschicht 4 (siehe Figur 2). Die Siliziumoxidschicht 3 und die Siliziumnitridschicht 4 werden so strukturiert, daß im Bereich der Öffnung 5 auch die Oberfläche der dotierten Gebiete 2 teilweise freigelegt ist.

Die Öffnung 5 weist parallel zur Hauptflache des Substrats 1 einen quadratischen Querschnitt auf. Der quadratische Querschnitt ist in [110]-Richtung des Substrats 1 aus (100)-Silizium orientiert. Die Öffnung 5 weist an der Oberfläche der Siliziumnitridschicht 4 eine Seitenlänge von etwa 350 nm auf.

Unter Verwendung der strukturierten Siliziumoxidschicht 3 und Siliziumnitridschicht 4 als Maske wird durch Molekularstrahlepitaxie von dotiertem Silizium auf der freiliegenden Oberfläche des Substrats 1 bzw. der dotierten Gebiete 2 eine Pyramide 6 aufgewachsen. Gleichzeitig wird auf der Oberfläche der Siliziumnitridschicht 4 eine dotierte Siliziumschicht 7 abgeschieden (siehe Figur 3). Die Molekularstrahlepitaxie wird bei einer Substrattemperatur während des Epitaxieprozesses zwischen 400°C und 700°C und mit einer Aufdampfrate zwischen 0,01 nm/sec und 0,5 nm/sec durchgeführt. Die Pyramide 6 wächst aufgrund eines physikalisch bedingten selbstorganisierenden Wachstumsprozesses auf, wobei die Seitenflächen der Pyramide 6 (111)-Flächen sind. Die Pyramide 6 wächst in einer Höhe von zum Beispiel etwa 250 nm auf. Gleichzeitig wächst die dotierte Siliziumschicht 7 amorph oder polykristallin in einer Dicke von zum Beispiel 300 nm auf. Die Pyramide 6 wird p-dotiert mit einer Dotierstoffkonzentration von zum Beispiel 3 x 10¹⁷ cm⁻³.

In einem Lift-off-Prozeß, in dem die Siliziumoxidschicht 3 selektiv zum Beispiel mit Flußsäure geätzt wird, wird die Siliziumoxidschicht 3, die Siliziumnitridschicht 4 und die darauf niedergeschlagene dotierte Siliziumschicht 7 entfernt.

Die Pyramide 6 reicht mit zwei gegenüberliegenden Seitenflächen jeweils bis auf die Oberfläche der dotierten Gebiete 2. Auf jedem der dotierten Gebiete 2 enden zwei Kanten der Pyramide 6.

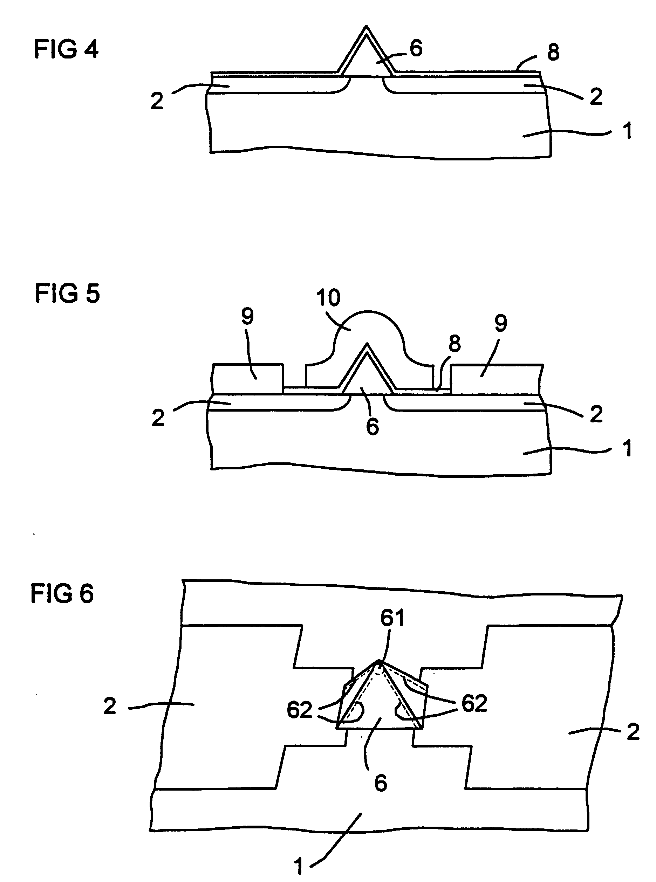

Es wird zum Beispiel durch thermische Oxidation oder durch eine CVD-Abscheidung ein Gateoxid 8 in einer Dicke von zum Beispiel 5 bis 10 nm aufgebracht (siehe Figur 4). Das Gateoxid 8 wird mindestens teilweise an der Oberfläche der dotierten Gebiete 2 entfernt (siehe Figur 5). Durch Abscheiden einer leitfähigen Schicht, zum Beispiel aus dotiertem Polysilizium, Metallsilizid oder Metall und Strukturieren werden Elektroden 9 zu den dotierten Gebieten 2 und eine Gateelektrode 10, die die Pyramide 6 überdeckt, gebildet.

Wird an die Gateelektrode 10 eine Spannung von zum Beispiel 1,5 V angelegt, so bildet sich im Bereich der Spitze der Pyramide 6 eine Inversionsschicht. Da die Pyramide 6 eine Spitze mit einem Krümmungsradius von < 10 nm aufweist, hat die Inversionsschicht eine Ausdehnung von etwa 10 nm . Die Inversionsschicht ist durch eine Potentialbarriere gegenüber den dotierten Gebieten 2 isoliert. Bei einer Erhöhung der Spannung an der Gateelektrode 10 vergrößert sich die Inversionsschicht und bildet sich auch entlang den Kanten der Pyramide 6 aus. Dadurch wird die Inversionsschicht an die Spitze der Pyramide 6 mit den dotierten Gebieten 2, die Source/Drain-Gebiete bilden, angeschlossen. Das in Figur 5 dargestellte Bauelement stellt daher einen Einzelelektronen-Transistor (single electron transistor) dar, der durch Variation der Gatespannung angesteuert werden kann.

Figur 6 zeigt eine Ansicht des Substrates 1 mit den dotierten Gebieten 2 und der Pyramide 6. Bei Anliegen eines ersten Spannungspegels an der Gateelektrode 10, die in der Ansicht in Figur 6 nicht enthalten ist, kommt es an der Spitze der Pyramide 6 zur Ausbildung einer Inversionsschicht 61, die einen Quantendot bildet. Die Inversionsschicht 61 ist, solange an der Gateelektrode der erste Spannungspegel der Steuerspannung anliegt, gegenüber dem Substrat 1 und den dotierten Gebieten 2 durch Potentialbarrieren isoliert. Liegt an der Gateelektrode ein zweiter Spannungspegel der Steuerspannung an, der höher ist als der erste Pegel, so bilden sich entlang der Kanten der Pyramide 6 weitere Inversionsschichten 62 aus. Über die Inversionsschichten 62 entlang den Kanten der Pyramide wird die Inversionsschicht 61 an der Spitze der Pyramide 6 mit den beiden dotierten Gebieten 2, auf deren Oberfläche die Inversionsschichten 62 enden, verbunden.

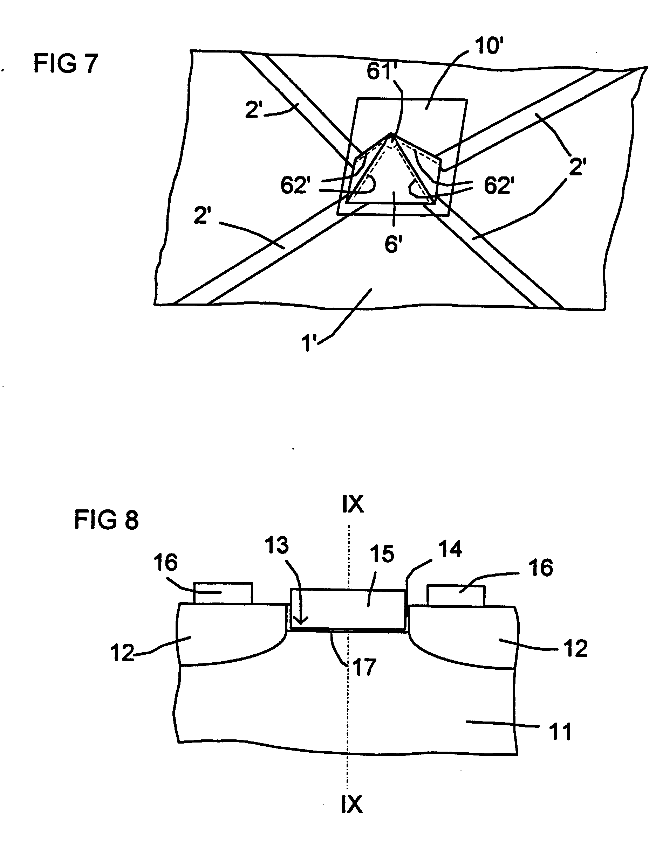

In Figur 7 ist eine Ansicht eines erfindungsgemäßen Bauelementes dargestellt, das analog der Beschreibung zu Figur 1 bis 5 hergestellt wird. Das Bauelement umfaßt ein Substrat 1' aus p⁻-dotiertem, monokristallinem Silizium mit vier n⁺-dotierten Gebieten 2'. Auf einer Hauptflache des Substrats 1' ist durch Molekularstrahlepitaxie von p⁻-dotiertem Silizium eine Pyramide 6' aufgewachsen, deren Kanten jeweils auf einem der dotierten Gebiete 2' enden. Die Pyramide 6' ist vollständig mit einem Gatedielektrikum und einer Gateelektrode 10' überdeckt.

Durch Anlegen eines ersten Pegels einer Steuerspannung an die Gateelektrode 10' kommt es zur Ausbildung einer Inversionsschicht 61' an der Spitze der Pyramide 6. Die Inversionsschicht 61' weist Abmessungen im Nanometerbereich auf und stellt einen Quantendot dar, der gegenüber dem Substrat 1' sowie den dotierten Gebieten 2' über Potentialbarrieren isoliert ist. Durch Anlegen eines zweiten Pegels der Steuerspannung an die Gateelektrode 10', der höher als der erste Pegel ist, bilden sich zusätzlich entlang den Kanten der Pyramide 6' Inversionsschichten 62' aus, über die die Inversionsschicht 61' mit den dotierten Gebieten 2' elektrisch verbunden wird. Figur 7 zeigt eine Verknüpfung von mehreren Quantendots über vier Anschlußgebiete 2'.

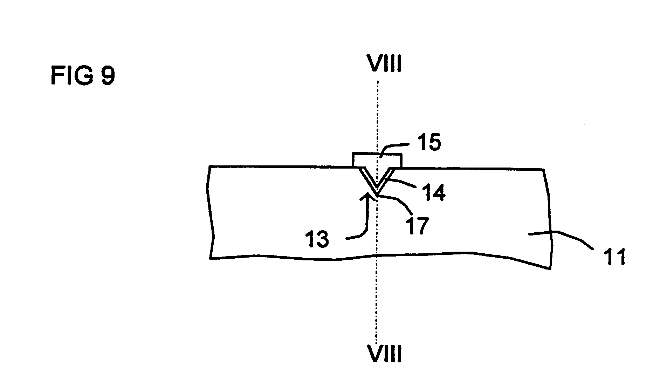

Anhand von Figur 8 und Figur 9 wird im folgenden ein Bauelement erläutert, das als Oberflächenstruktur eine Vertiefung mit V-förmigem Querschnitt aufweist. Der in Figur 8 gezeigte Schnitt durch das Bauelement ist in Figur 8 mit VIII-VIII eingetragen. Der in Figur 9 gezeigte Schnitt durch das Bauelement ist in Figur 8 mit IX-IX eingetragen. Dieses Bauelement ist aber nicht Teil der beanspruchten Erfindung.

In einem Substrat 11 aus zum Beispiel monokristallinem, p-dotiertem Silizium werden zum Beispiel durch maskierte Ionenimplantation zwei dotierte Gebiete 12 gebildet. Die dotierten Gebiete 12 werden zum Beispiel n⁺-dotiert. Unter Verwendung einer Maske mit rechteckigem Querschnitt wird in einem kristallorientierungsabhängigen Ätzverfahren, zum Beispiel mit KOH, zwischen den beiden dotierten Gebieten 12 ein Graben 13 mit V-förmigem Querschnitt geätzt. Die Kante 17 des V-förmigen Querschnitts verläuft dabei von dem einen dotierten Gebiet 12 zum anderen.

Die Oberfläche des Grabens 13 wird mit einem Gateoxid 14 zum Beispiel durch thermische Oxidation oder durch CVD-Abscheidung von SiO₂ versehen. Auf der Oberfläche des Gateoxids 14 wird eine Gateelektrode 15 aus zum Beispiel dotiertem Polysilizium, Metallsilizid oder einem Metall hergestellt. Auf der Oberfläche der dotierten Gebiete 12 werden Elektroden 16 aus leitfähigem Material, zum Beispiel dotiertem Polysilizium, Metallsilizid oder Metall gebildet. Durch Anlegen einer Steuerspannung von zum Beispiel 1,5 V an die Gateelektrode 15 wird an der Kante 17 des Grabens 13 eine Inversionsschicht ausgebildet, über die die beiden dotierten Gebiete 12 miteinander verbunden werden.

## Patentansprüche

1. Mikroelektronisches Bauelement,
- mit einem Substrat (1), das mindestens im Bereich einer Hauptflache monokristallines Silizium umfaßt und das im Bereich der Hauptflache mindestens eine Oberflächenstruktur (6) umfaßt, die mindestens drei sich in einem Schnittpunkt schneidende Flächen aufweist, die sich paarweise in einer Schnittgeraden schneiden,
- mit einem Gatedielektrikum (8), das die Oberflächenstruktur (6) mindestens im Bereich der sich schneidenden Flächen überdeckt,
- mit einer Gateelektrode (10), die an der Oberfläche des Gatedielektrikums (8) angeordnet ist,
- mit mindestens zwei leitfähigen Gebieten (2), die im Bereich der Hauptfläche an jeweils mindestens einer der Schnittgeraden angeordnet sind, die gegenüber dem Substrat (1) isoliert sind und zwischen den durch Anlegen einer Steuerspannung an die Gateelektrode (10) ein Stromfluß über eine Inversionsschicht steuerbar ist, die sich bei Anlegen der Steuerspannung an der Gateelektrode (15) entlang dem Schnittbereich der sich schneidenden Flächen und im Bereich des Schnittpunktes ausbildet.

2. Bauelement nach Anspruch 1,
- bei dem die Oberflächenstruktur in Form einer Pyramide (6) aus monokristallinem Silizium gebildet wird, die über die Hauptflache herausragt und bei dem die leitfähigen Gebiete (2) als Diffusionsgebiete im Substrat (1) realisiert sind und
- bei dem die Oberflächenstruktur (6) und das Substrat (1) von einem ersten Leitfahigkeitstyp dotiert sind und die leitfähigen Gebiete (2) von einem zweiten zum ersten entgegengesetzten Leitfähigkeitstyp dotiert sind.

3. Verfahren zur Herstellung eines mikroelektronischen Bauelementes,
- bei dem ein Substrat (1), das mindestens im Bereich einer Hauptfläche monokristallines Silizium umfaßt, im Bereich der Haupt fläche mit einer Oberflächenstruktur (6) versehen wird, die mindestens zwei sich in einem Schnittbereich schneidende Flächen aufweist,
- bei dem zur Herstellung der Oberflächenstruktur (6) eine Maske (3, 4) erzeugt wird, die die Hauptfläche außerhalb der Oberflächenstruktur (6) abdeckt,
- bei dem durch epitaktisches Aufwachsen von Silizium auf der freiliegenden Hauptfläche des Substrats (1) die Oberflächenstruktur in Form einer Pyramide (6) aus monokristallinem Silizium gebildet wird,
- bei dem ein Gatedielektrikum (8) erzeugt wird, das mindestens die sich schneidenden Flächen der Oberflächenstruktur (6) überdeckt,
- bei dem an der Oberfläche des Gatedielektrikums (8) eine Gateelektrode (10) erzeugt wird,
- bei dem im Bereich der Hauptfläche des Substrats (1) zwei leitfähige Gebiete (2) erzeugt werden, die gegenüber dem Substrat (1) isoliert sind und zwischen denen durch Anlegen einer Steuerspannung an die Gateelektrode (10) ein Stromfluß über eine Inversionsschicht steuerbar ist, die sich bei Anlegen der Steuerspannung an die Gateelektrode (10) entlang dem Schnittbereich der sich schneidenden Flächen ausbildet.

4. Verfahren nach Anspruch 3,
- bei dem die Maske aus einer Doppelschicht, die eine Siliziumoxidschicht (3) und eine Siliziumnitridschicht (4) umfaßt, so gebildet wird, daß die Siliziumoxidschicht (3) Unterätzungen (5a) unter die Siliziumnitridschicht (4) aufweist,
- bei dem die Pyramide (6) durch lokale Molekularstrahlepitaxie erzeugt wird.

5. Verfahren nach Anspruch 3 oder 4,
- bei dem das Substrat (1) von einem ersten Leitfähigkeitstyp dotiertes Silizium umfaßt,
- bei dem vor der Bildung der Pyramide (6) die leitfähigen Gebiete (2) als Diffusionsgebiete, die von einem zweiten zum ersten entgegengesetzten Leitfahigkeitstyp dotiert sind, im Substrat (1) erzeugt werden,
- bei dem die Pyramide (6) in situ vom ersten Leitfahigkeitstyp dotiert wird,
- bei dem nach der Bildung der Pyramide (6) die Maske (3, 4) entfernt wird.

## Claims

1. Microelectronic component,
- having a substrate (1) which comprises monocrystalline silicon at least at a main face, and which comprises, at the main face, at least one surface structure (6) having at least three faces intersecting at an intersection point which intersect in pairs on a straight intersection line,
- having a gate dielectric (8) which covers the surface structure (6) at least at the intersecting faces,
- having a gate electrode (10) which is arranged on the surface of the gate dielectric (8),
- having at least two conductive regions (2), which are arranged at the main face, in each case on at least one of the straight intersection lines and are insulated from the substrate (1), and between which, by applying a control voltage to the gate electrode (10), it is possible to control a current flow across an inversion layer which is formed along the intersection zone of the intersecting faces and at the intersection point when the control voltage is applied to the gate electrode (15).

2. Component according to Claim 1,
- in which the surface structure is formed as a monocrystalline silicon pyramid (6) which projects above the main face, and in which the conductive regions (2) are produced as diffusion regions in the substrate (1), and
- in which the surface structure (6) and the substrate (1) are doped with a first conductivity type, and the conductive regions (2) are doped with a second conductivity type, opposite to the first.

3. Process for producing a microelectronic component,
- in which a substrate (1) comprising monocrystalline silicon at least at a main face is provided at the main face with a surface structure (6) having at least two faces intersecting at an intersection zone,
- in which, in order to produce the surface structure (6), a mask (3, 4) which covers the main face outside the surface structure (6) is produced,
- in which the surface structure is formed as a monocrystalline silicon pyramid (6) by epitaxial growth of silicon on the exposed main face of the substrate (1),
- in which a gate dielectric (8) which covers at least the intersecting faces of the surface structure (6) is produced,
- in which a gate electrode (10) is produced on the surface of the gate dielectric (8),
- in which, at the main face of the substrate (1), two conductive regions (2) are produced, which are insulated from the substrate (1) and between which, by applying a control voltage to the gate electrode (10), it is possible to control a current flow across an inversion layer which is formed along the intersection zone of the intersecting faces when the control voltage is applied to the gate electrode (10).

4. Process according to Claim 3,
- in which the mask is formed, from a double layer comprising a silicon oxide layer (3) and a silicon nitride layer (4), in such a way that the silicon oxide layer (3) has undercut etches (5a) under the silicon nitride layer (4),
- in which the pyramid (6) is produced by local molecular beam epitaxy.

5. Process according to Claim 3 or 4,
- in which the substrate (1) comprises silicon doped with a first conductivity type,
- in which, before the pyramid (6) is formed, the conductive regions (2) are produced in the substrate (1) as diffusion regions which are doped with a second conductivity type, opposite to the first,
- in which the pyramid (6) is doped in situ with the first conductivity type,
- in which the mask (3, 4) is removed after the pyramid (6) is formed.

## Revendications

1. Composant microélectronique,
- avec un substrat (1), qui comprend au moins dans la zone d'une surface principale du silicium monocristallin et qui comprend dans la zone de la surface principale au moins une structure de surface (6), qui présente au moins trois surfaces se coupant en une intersection, lesdites surfaces se coupant par paire en une droite d'intersection,
- avec un diélectrique de grille (8), qui recouvre la structure de la surface (6) au moins dans la zone des surfaces se coupant,
- avec une électrode de grille (10), qui est disposée sur la surface du diélectrique de grille (8),
- avec au moins deux zones conductrices (2), qui sont disposées dans la zone de la surface principale sur à chaque fois au moins une des droites d'intersection, qui sont isolées par rapport au substrat (1) et entre lesquelles, par application d'une tension de commande à l'électrode de grille (10), un flux de courant est commandable par l'intermédiaire d'une couche d'inversion, qui se forme lors de l'application d'une tension de commande à l'électrode de grille (15) le long de la zone d'intersection des surfaces se coupant et dans la zone du point d'intersection.

2. Composant selon la revendication 1,
- pour lequel la structure de surface est formée en forme d'une pyramide (6) en silicium monocristallin, ladite pyramide dépassant la surface principale et pour lequel les zones conductrices (2) sont réalisées comme zone de diffusion dans le substrat (1) et
- pour lequel la structure de surface (6) et le substrat (1) sont dopés par un premier type de conductibilité et les zones conductrices (2) sont dopées par un deuxième type de conductibilité opposé au premier.

3. Procédé pour la fabrication d'un composant microélectronique,
- pour lequel un substrat (1), qui comprend au moins dans la zone d'une surface principale du silicium monocristallin, est pourvu dans la zone de la surface principale d'une structure de surface (6), qui présente au moins deux surfaces se coupant dans une zone d'intersection,
- pour lequel pour la fabrication de la structure de surface (6) est fabriqué un masque (3, 4), qui recouvre la surface principale en dehors de la structure de surface (6),
- pour lequel la structure de surface est formée en forme d'une pyramide (6) en silicium monocristallin par croissance épitaxiale de silicium sur la surface principale dégagée du substrat (1),
- pour lequel est fabriqué un diélectrique de grille (8), qui recouvre au moins les surfaces de la structure de surface (6) se coupant,
- pour lequel une électrode de grille (10) est fabriqué sur la surface du diélectrique de grille (8),
- pour lequel dans la zone de la surface principale du substrat (1) sont fabriquées deux zones conductrices (2), qui sont isolées par rapport au substrat (1) et entre lesquelles par l'intermédiaire de l'application d'une tension de commande à l'électrode de grille (10), un flux de courant est commandable par l'intermédiaire d'une couche d'inversion, qui se forme lors de l'application de la tension de commande à l'électrode de grille (10) le long de la zone d'intersection des surfaces se coupant.

4. Procédé selon la revendication 3,
- pour lequel le masque est formé à partir d'une double couche, qui comprend une couche d'oxyde de silicium (3) et une couche de nitrure de silicium (4), de telle sorte que la couche d'oxyde de silicium (3) présente des attaques sous jacentes (5a) sous la couche de nitrure de silicium (4),
- pour lequel la pyramide (6) est fabriquée par épitaxie par faisceau moléculaire locale.

5. Procédé selon la revendication 3 ou 4,
- pour lequel le substrat (1) comprend du silicium dopé par un premier type de conductibilité,
- pour lequel avant la formation de la pyramide (6), les zones conductrices (2) sont fabriquées dans le substrat (1) comme zones de diffusion, qui sont dopées, par un deuxième type de conductibilité opposé au premier,
- pour lequel la pyramide (6) est dopée in situ par le premier type de conductibilité,
- pour lequel après la fabrication de la pyramide (6), le masque (3, 4) est éliminé.
